# EUROPÄISCHE PATENTSCHRIFT

(11) **EP 1 415 376 B1**
(45) Veröffentlichungstag und Bekanntmachung des Hinweises auf die Patenterteilung: **29.11.2006**
(21) Anmeldenummer: 02754471.7
(22) Anmeldetag: 01.08.2002
(51) Int. Cl.: H01S 5/10

(54) **MEHRTEILIGER LASER**
MULTI-COMPONENT LASER
LASER COMPOSE

(30) Priorität: 09.08.2001 DE 10139090
(43) Veröffentlichungstag der Anmeldung: 06.05.2004
(73) Patentinhaber: Osram Opto Semiconductors GmbH, 93049 Regensburg (DE)
(72) Erfinder: BEHRINGER, Martin, 93051 Regensburg (DE); EBERHARD, Franz, 93059 Regensburg (DE); LUFT, Johann, 93195 Wolfsegg (DE)
(74) Vertreter: Epping - Hermann - Fischer
(86) Internationale Anmeldenummer: PCT/DE2002/002828
(87) Internationale Veröffentlichungsnummer: WO 2003/017442

(56) Entgegenhaltungen:
- EP-A- 0 516 263
- WO-A-91/02391
- WO-A-97/30495
- US-A- 5 879 961
- LIEW S K ET AL: "COHERENT CONTINUOUS WAVE OPERATION OF 10 X 10 X 2 GRATING-SURFACE-EMITTING DIODE LASER ARRAY IN A RING CONFIGURATION" JOURNAL OF APPLIED PHYSICS, AMERICAN INSTITUTE OF PHYSICS. NEW YORK, US, Bd. 70, Nr. 12, 15. Dezember 1991 (1991-12-15), Seiten 7645-7647, XP000278235 ISSN: 0021-8979
- MADHAN RAJ M ET AL: "MULTIPLE MICRO-CAVITY LASER WITH LAMBDA/4-WIDE DEEP GROOVES BURIED WITH BENZOCYCLOBUTENE" 1999 11TH. INTERNATIONAL CONFERENCE ON INDIUM PHOSPHIDE AND RELATED MATERIALS. CONFERENCE PROCEEDINGS. IPRM DAVOS, MAY 16 - 20, 1999, INTERNATIONAL CONFERENCE ON INDIUM PHOSPHIDE AND RELATED MATERIALS, NEW YORK, NY: IEEE, US, Bd. CONF. 11, 16. Mai 1999 (1999-05-16), Seiten 207-210, XP000931431 ISBN: 0-7803-5563-6
- PATENT ABSTRACTS OF JAPAN vol. 005, no. 055 (E-052), 16. April 1981 (1981-04-16) -& JP 56 006492 A (SHARP CORP), 23. Januar 1981 (1981-01-23)
- EVANS G A ET AL: "CHARACTERISTICS OF COHERENT TWO-DIMENSIONAL GRATING SURFACE EMITTING DIODE LASER ARRAYS DURING CW OPERATION" IEEE JOURNAL OF QUANTUM ELECTRONICS, IEEE INC. NEW YORK, US, Bd. 27, Nr. 6, 1. Juni 1991 (1991-06-01), Seiten 1594-1608, XP000229860 ISSN: 0018-9197
- CARLIN J F ET AL: "THE DUAL WAVELENGTH BI-VERTICAL CAVITY SURFACE-EMITTING LASER" APPLIED PHYSICS LETTERS, AMERICAN INSTITUTE OF PHYSICS. NEW YORK, US, Bd. 75, Nr. 7, 16. August 1999 (1999-08-16), Seiten 908-910, XP000875537 ISSN: 0003-6951

## Beschreibung

Die Erfindung betrifft eine Vorrichtung zur Emission von Laserstrahlung mit einer oder mehreren innerhalb eines Resonators angeordneten gepumpten aktiven Zone eines Halbleiterlasers.

Derartige Laser sind allgemein bekannt. Halbleiterlaser werden dabei üblicherweise in zwei Ausführungsformen hergestellt. Bei kantenemittierenden Laserdioden erfolgt die Emission in Ausdehnungsrichtung der gepumpten aktiven Schicht und die Laserstrahlung tritt über die Ränder der aktiven Schicht aus. Bei dieser Art von Laserdioden ist die Strahlqualität im allgemeinen schlecht, da der kantenemittierende Laser nicht in einer Mode und nicht ausschließlich in der Grundmode oszilliert, so daß die Laserstrahlung in einen weiten Winkelbereich emittiert wird. Dieses Problem ist insbesondere bei kantenemittierenden Laserdioden ausgeprägt, deren aktive Zone quer zur optischen Achse des Resonators weit ausgedehnt ist.

Neben den kantenemittierenden Laserdioden sind auch oberflächenemittierende Dioden bekannt, bei denen die Laserstrahlung im rechten Winkel zur gepumpten aktiven Schicht emittiert wird. Die oberflächenemittierenden Laserdioden sind zum einen mit hohen elektrischen Widerständen behaftet, die auf der begrenzten Dotierbarkeit zu beiden Seiten der aktiven Zonen ausgebildeten Spiegelschichten beruhen. Die Widerstände lassen zwar unter anderem auch dadurch verringern, daß der Durchmesser der aktiven Zone vergrößert wird. Dies führt jedoch im allgemeinen dazu, daß beim Betrieb des Lasers höhere Moden anspringen, die die Strahlqualität verschlechtern.

EP-A-0 516 263 offenbart einen laser gemäß dem Oberbegriff von Anspruch 1.

Ausgehend von diesem Stand der Technik liegt der Erfindung die Aufgabe zugrunde, eine Vorrichtung zur Emission von Laserstrahlung hoher Leistung mit guter Strahlqualität anzugeben.

Diese Aufgabe wird erfindungsgemäß durch den Gegenstand von Anspruch 1 gelöst. Die aktive Zone ist durch Freistrahlbereiche ohne seitliche Wellenführung in wenigstens zwei räumlich getrennte aktive Zonen unterteilt.

Die räumliche Trennung der beiden Pumpzonen ist derart daß nur jeweils die Grundmode in die jeweils andere Pumpzone einkoppelt und dadurch verstärkt wird oder die Grundmode wesentlich effektiver als alle anderen Moden einkoppelt. Denn die übrigen Moden strahlen in Raumwinkel ab, die wesentlich größer als der Raumwinkel sind, unter dem die gegenüberliegende Pumpzone von der jeweiligen Pumpzone aus erscheint und somit werden diese höheren Moden nicht in der anderen Pumpzone verstärkt. Diese höheren Moden erfahren also eine geringere Verstärkung pro Resonatorumlauf als die Grundmode und kommen daher bei entsprechender elektrischer Pumpleistung nicht über die Laserschwelle.

Bei einer bevorzugten Ausführungsform der Erfindung weist die Vorrichtung eine Reihe von Breitstreifenlaser auf, deren Resonator von den außen liegenden Spiegelflächen der am Ende angeordnete Breitstreifenlaser gebildet ist.

Bei den Breitstreifenlasern ist das Problem des Anschwingens Moden höherer Ordnung besonders ausgeprägt. Es ist daher von Vorteil, eine Reihe von Breitstreifenlaser im Abstand zueinander anzuordnen, um zu gewährleisten, daß nur jeweils eine Grundmode anschwingt oder dadurch der Anteil der höheren Moden deutlich reduziert und so die Strahlqualität entsprechend verbessert wird.

Zweckmäßigerweise wird in den Freistrahlbereich zwischen die einzelnen Breitstreifendiodenlasern eine Zylinderlinse angeordnet, deren Brennlinie entlang der Austrittskante der Laserstrahlung aus dem Breitstreifenlaser liegt.

Durch diese Anordnung wird die Grundmode des austretenden Lichtstrahls optimal gebündelt und in die jeweils benachbarte aktive Zone gelenkt.

Bei einer Ausführungsform der Erfindung sind die beiden Breitstreifenlaser in einem Substrat ausgebildet. Zwischen den beiden Breitstreifenlasern liegt im Substrat ein ungepumpter Bereich vor, der so dimensioniert ist, daß höhere Mode aufgrund des dort fehlenden lateralen Wellenleiters die aktive Zone und damit den Verstärkungsbereich verlassen können. Allein die Grundmode ist in der Lage, den umgepumpten Bereich zu durchqueren und auf der gegenüberliegenden Seite wieder in die aktive Zone des gegenüberliegenden Breitstreifenlasers einzutreten. Dadurch wird die Schwellenstrombedingung für höhere Moden sehr stark angehoben, so daß der Breitstreifenlaser überwiegend in der Grundmode oszilliert.

In einem weiteren Ausführungsbeispiel weist die Vorrichtung zwei oberflächenemittierende Laser auf, die jeweils mit einer entspiegelten Oberseite einander zugewandt im Abstand angeordnet sind.

Durch die Verwendung zweier oberflächenemittierender Laser mit nur jeweils einem Spiegel kann der elektrische Widerstand jedes oberflächenemittierenden Lasers auf etwa die Hälfte reduziert werden. Außerdem kann durch die Beabstandung zwischen den oberflächenemittierenden Laser erreicht werden, daß höhere Moden, die in einen größeren Raumwinkel als die Grundmode emittiert werden, den Resonator verlassen und nicht mehr verstärkt werden, so daß die Vorrichtung im Wesentlichen nur im Grundmode oszilliert.

Weitere vorteilhafte Ausgestaltungen sind Gegendstand der abhängigen Ansprüche.

Nachfolgend wird ein Ausführungsbeispiel der Erfindung anhand der beigefügten Zeichnung erläutert. Es zeigen:
- Figur 1: einen Querschnitt durch einen Breitstreifenlaser;
- Figur 2: eine perspektivische Ansicht einer Laseranordnung mit zwei gegenüberliegenden Breitstreifenlaser, wobei in den zwischen den Breitstreifenlaser liegenden Freistrahlbereich Zylinderlinsen eingebracht sind;
- Figur 3: eine perspektivische Ansicht eines in einem Substrat ausgebildeten Paares von Breitstreifenlasern;
- Figur 4: eine Laseranordnung mit zwei gegenüberliegenden oberflächenemittierenden Lasern;
- Figur 5: eine weitere abgewandelte Laseranordnung mit zwei gegenüberliegenden oberflächenemittierenden Lasern;
- Figur 6: eine Darstellung einer weiteren abgewandelten Ausführungsform der Laseranordnung aus Figur 5.

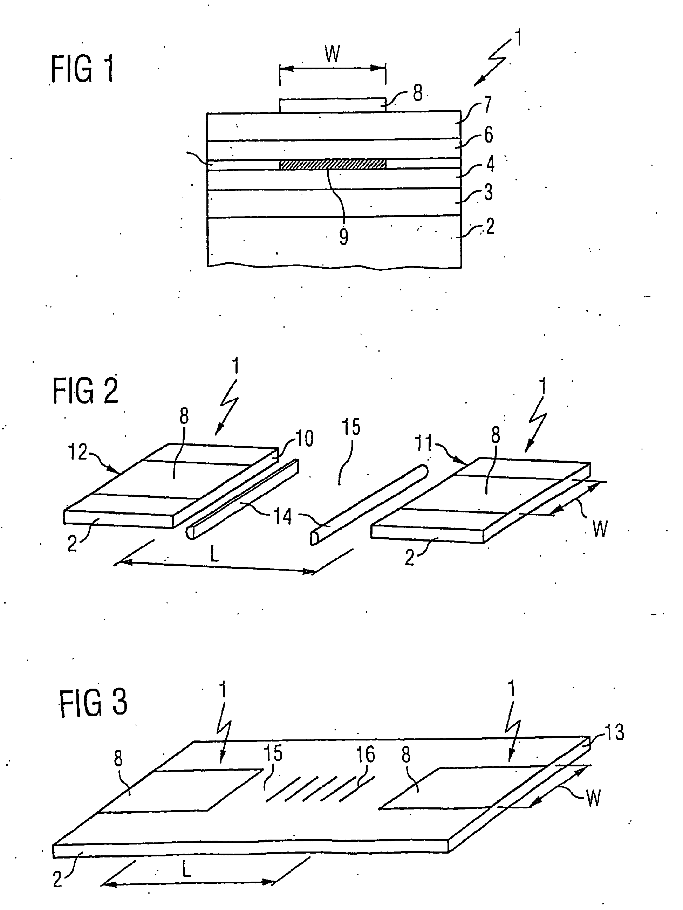

Gemäß dem in Figur 1 dargestellten Querschnitt durch einen Breitstreifenlaser 1 ist auf ein Substrat 2 eine untere Barriereschicht 3 aufgebracht. Die Barriereschicht 3 weist beispielsweise die Zusammensetzung Al_{0,6}Ga_{0,4}As und eine Dicke von 1 µm auf. An die untere Barrierenschicht 3 schließt sich eine untere Wellenleiterschicht 4 an, die üblicherweise die Zusammensetzung Al_{0,3}Ga_{0,7}As aufweist und etwa 0,5 µm dick ist. Das vom Breitstreifenlaser 1 emittierte Licht wird in einer aktiven Schicht 5 erzeugt, die lediglich eine Dicke von etwa 10 nm aufweist und einen Quantentrog bildet. Die Materialzusammensetzung der aktiven Schicht hängt von der gewünschten Wellenlänge des emittierten Lichts ab. Üblicherweise setzt sich die aktive Schicht aus AlₓIn_{y}Ga_{1-x-y}As zusammen wobei 0 <= x <= 0,3 und 0,05 <= y <= 0,3 gilt. Oberhalb der aktiven Schicht 5 befindet sich eine obere Wellenleiterschicht 6, die von einer oberen Barriereschicht 7 abgedeckt ist. Die Dicke und die Zusammensetzung der oberen Wellenleiterschicht 6 und der oberen Barriereschicht 7 entsprechen jeweils der Dicke und Zusammensetzung der unteren Barriereschicht 3 und unteren Wellenleiterschicht 4. Auf der oberen Barrierenschicht 7 ist ein Breitstreifenkontakt 8 ausgebildet, der zusammen mit einem auf der Rückseite des Substrats 2 angeordneten rückseitigen Kontakt die aktive Schicht 5 mit Strom versorgt. Dabei bestimmt die räumliche Ausdehnung des Breitstreifenkontakts 8 die Ausdehnung einer lichtemittierenden aktiven Zone 9 in der aktiven Schicht 5.

Die in Figur 1 im Querschnitt dargestellten Breitstreifenlaser 1 zeichnen sich durch eine hohe Leistung und durch eine lange Lebensdauer aus. Allerdings ist die Strahlqualität einzelner Breitstreifenlaser meist schlecht, da der Breitstreifenlaser 1 nicht nur in einem Mode und nicht ausschließlich in der Grundmode oszilliert, so daß die Laserstrahlung in einem weiten Winkelbereich emittiert wird.

Es wird daher vorgeschlagen, wenigstens zwei Breitstreifenlaser 1 in Reihe hintereinander im Abstand so anzuordnen, daß lediglich die Grundmode jeweils eines Breitstreifenlasers in die gepumpte aktive Zone 9 eines benachbarten Breitstreifenlasers 1 einkoppelt. Die Moden höherer Ordnung treten aufgrund ihrer größeren Divergenz lediglich teilweise in die aktive Zone 9 benachbarter Breitstreifenlaser ein und werden daher im Vergleich zur Grundmode lediglich geringfügig verstärkt. Dadurch wird die Schwellenstrombedingung für höhere Moden sehr stark angehoben, so daß die Laseranordnung überwiegend in der Grundmode oszilliert.

In Figur 2 ist ein Ausführungsbeispiel mit zwei Breitstreifenlasern dargestellt, die jeweils in einem Abstand L angeordnet sind. Die Länge der Strecke kann zwischen 1 µm und 10 m betragen. Um die Breitstreifenlaser 1 zu einer Laseranordnung zu koppeln, weisen die einander zugewandten Facetten 10 und 11 jeweils eine auf die Strahlungsenergie bezogene Reflektivität unterhalb von 1% auf. Von den außen liegenden Facetten 12 und 13 weist wenigstens eine eine Reflektivität oberhalb von 90% und die andere eine Reflektivität von beispielsweise 40% auf. Die außenliegenden Facetten bilden dadurch einen Resonator, wobei die Facetten 12 und 13 die Funktion der Spiegelflächen übernehmen.

Um auch die Divergenz der Grundmode in Richtung der Normalen der aktiven Zone 9, also im rechten Winkel zur aktiven Zone 9, zu verringern, sind Zylinderlinsen 14 vorgesehen, deren Brennlinie vorzugsweise entlang der Austrittskante der aktiven Zone 9 an den innenliegenden Facetten 10 und 11 verläuft. Durch die Zylinderlinsen 14 wird die aufgrund der Beugung große Divergenz der Grundmode in Richtung der Normalen, der aktiven Schicht 5 verringert, oder das Licht in diese Richtung sogar kollimiert. Durch diese Maßnahme wird die Grundmode nahezu vollständig in den benachbarten Breitstreifenlaser 1 eingekoppelt und dadurch die Laserschwelle für die Grundmode abgesenkt.

Es ist auch denkbar, wie in Figur 3 dargestellt, die Breitstreifenlaser 1 auf einem gemeinsamen Substrat 2 mit einem gemeinsamen Schichtaufbau auszubilden. Dabei ist es nicht unbedingt notwendig, den Freistrahlbereich 15 auszuätzen. Es genügt, wenn im Freistrahlbereich die Absorption des Materials reduziert wird. Dies kann beispielsweise durch eine lokale Wärmebehandlung des Freistrahlbereiches erreicht werden, durch die Aluminium aus den an die aktive Schicht 5 angrenzenden Wellenleiterschichten 4 und 6 in die aktive Schicht 5 eindiffundiert und/oder Indium aus der aktiven Schicht ausdiffundiert. Denn dadurch wird die Bandlücke der aktiven Schicht im Freistrahlbereich 15 erhöht, so daß die von den aktiven Zonen 9 emittierten Photonen im Freistrahlbereich nicht absorbiert werden.

Falls die Laseranordnung aus Figur 3 nur auf einer bestimmten Frequenz oszillieren soll, ist es von Vorteil, wenn im Freistrahlbereich ein frequenzselektives Element, beispielsweise ein Bragg-Gitter 16 eingebracht wird. Derartige Bragg-Gitter 16 sind dem Fachmann bekannt und nicht Gegenstand der Erfindung.

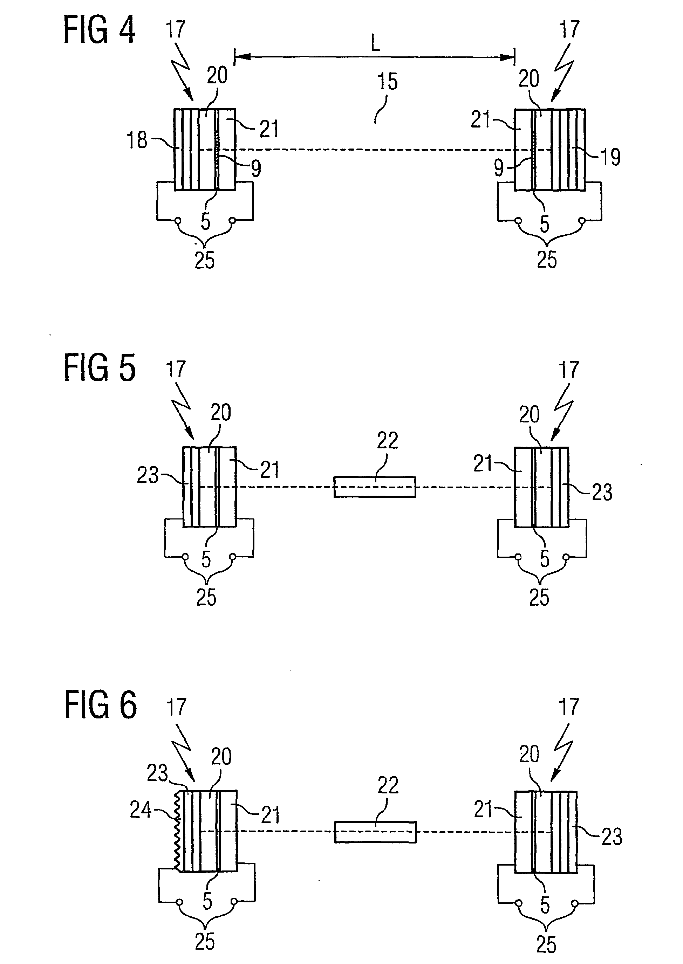

In den Figuren 4 bis 6 sind weitere Ausführungsbeispiele dargestellt, bei denen die Laseranordnung zwei gegenüberliegende oberflächenemittierende Laser 17 aufweist. Die oberflächenemittierenden Laser 17 werden auch als VCSEL oder VECSEL bezeichnet. Die oberflächenemittierenden Laser verfügen über rückseitige Bragg-Spiegel 18 und 19, von denen einer eine Reflektivität nahe 100% und der andere eine Reflektivität im Bereich von < 99% aufweist. Auf die Bragg-Spiegel 18 und 19 ist eine untere Zwischenschicht 20 aufgebracht, an die sich die aktive Schicht 5 anschließt. Die aktiven Schichten 5 sind wiederum von einer oberen Zwischenschicht 21 abgedeckt. Die Bragg-Spiegel 18 und 19 sind üblicherweise auf der Basis von AlGaAs-Schichten hergestellt. Die Zwischenschichten 20 und 21 sowie die aktiven Schichten 5 beruhen auf dem bereits erwähnten Materialsystem AlGaInAs.

Die oberflächenemittierenden Laser 17 sind in einem Abstand von 1 µm bis 10 m angeordnet. Durch den großen Abstand zwischen den beiden oberflächenemittierenden Lasern 17 wird erreicht, daß nur die Grundmode in dem von den beiden Bragg-Spiegeln 18 und 19 gebildeten Resonator geführt ist und daß Moden höherer Ordnung, die von den oberflächenemittierenden Laser 17 in große Raumwinkel emittiert werden, den Resonator verlassen und nicht mehr verstärkt werden. Die beiden oberflächenemittierenden Laser 17 müssen daher so justiert sein, daß jeweils die Grundmode in die aktive Schicht 5 des gegenüberliegenden oberflächenemittierenden Lasers 17 abgebildet wird.

In Figur 5 ist ein weiteres Ausführungsbeispiel dargestellt, bei dem in den Freistrahlbereich 15 zwischen den beiden oberflächenemittierenden Lasern 17 ein optisches Element 22 eingebracht ist. Dieses optische Element 22 kann abbildende Eigenschaften haben, um zu gewährleisten, daß die Grundmode jeweils eines oberflächenemittierenden Lasers 17 in die aktive Schicht 5 des jeweils anderen oberflächenemittierenden Lasers 17 abgebildet wird. Das optische Element 22 kann aber auch dazu dienen, einen Teil der von der Laseranordnung erzeugten Strahlung seitlich aus dem Freistrahlbereich 15 auszukoppeln. In diesem Fall können die oberflächenemittierenden Laser 17 jeweils mit einem Bragg-Spiegel 23 ausgestattet sein, der eine Reflektivität von nahezu 100% aufweist.

Schließlich sei angemerkt, daß wie in Figur 6 dargestellt, einer oder beide der Bragg-Spiegel 18, 19 und 23 mit einer Metallisierungsschicht 24 versehen sein können.

Zum Betrieb der oberflächenemittierenden Laser 17 wird eine Versorgungsspannung an Anschlüsse 25 angelegt.

Die in den Figuren 4 bis 6 dargestellte Laseranordnung mit zwei oberflächenemittierenden Lasern hat neben der geringen Strahlendivergenz des erzeugten Laserstrahls noch den Vorteil, daß bei den oberflächenemittierenden Lasern 17 auf den Bragg-Spiegel verzichtet werden kann, der üblicherweise bei herkömmlichen oberflächenemittierenden Lasern auf der oberen Zwischenschicht 21 angeordnet ist. Da auf den oberen Bragg-Spiegel verzichtet werden kann, weisen die oberflächenemittierenden Laser 17 einen elektrischen Widerstand auf, der gegenüber herkömmlichen oberflächenemittierenden Lasern auf etwa die Hälfte oder weniger reduziert ist. Entsprechend kleiner ist die Verlustleistung, die in dem oberflächenemittierenden Laser 17 aufgrund des Innenwiderstands auftritt.

Ferner sei angemerkt, daß die Laseranordung auch in anderen Materialsystemen verwirklicht werden kann. Für eine Emission von Laserstrahlung im blau-grünen Wellenlängenbereich kommt beispielsweise das Materialsystem auf der Basis von AlGaInN in Frage. Für eine Emission der Laserstrahlung im roten Wellenlängenbereich eignet sich die Materialsysteme InGaAlP und GaAs. Weiterhin kommen auch II-VI-Verbindungshalbleiter, wie beispielsweise aus dem System CdBeMgZn, SeTe und SSeTeO in Frage.

## Patentansprüche

1. Vorrichtung zur Emission von Laserstrahlung mit einer innerhalb eines Resonators (12, 13, 18, 19, 23) angeordneten gepumpten aktiven Zone eines Halbleiterlasers, wobei die aktive Zone durch Freistrahlbereiche (15) ohne seitliche Wellenführung in wenigstens zwei räumlich getrennte aktive Zonen (9) unterteilt ist, **dadurch gekennzeichnet, daß** die eine gepumpte aktive Zone (a) von der anderen gepumpten aktiven Zone (9) aus unter einen ausreichend kleinen Raumwinkel erscheint, so daß höhere Moden des Resonators (12, 13, 18, 19, 23) eine geringere Verstärkung pro Resonatorumlauf erfahren als eine Grundmode des Resonators (12, 13, 18, 19, 23).

2. Vorrichtung nach Anspruch 1, bei der wenigstens zwei zumindest einseitig entspiegelte Halbleiterlaser (1, 17) in Reihe angeordnet sind, wobei der Resonator von außenliegenden Spiegelelementen (12, 13, 18, 19, 23) der am Ende der in Reihe angeordneten Halbleiterlaser (1, 17) gebildet ist.

3. Vorrichtung nach Anspruch 2, bei der die Halbleiterlaser zwei oberflächenemittierende Laser (17) sind, die jeweils mit einer entspiegelten Oberseite einander zugewandt im Abstand angeordnet sind.

4. Vorrichtung nach Anspruch 2, bei der die Halbleiterlaser zwei Breitstreifenlaser (1) sind, die jeweils mit einer entspiegelten Endfläche (10, 11) einander zugewandt im Abstand angeordnet sind.

5. Vorrichtung nach Anspruch 4, bei dem die beiden Breitstreifenlaser (1) auf einem Substrat (2) ausgebildet sind.

6. Vorrichtung nach einem der Ansprüche 2 bis 5, bei der die Halbleiterlaser (1, 17) mit ihren optischen Achsen parallel zueinander ausgerichtet sind.

7. Vorrichtung nach einem der Ansprüche 2 bis 6, bei der die Halbleiterlaser (1, 17) im Abstand zwischen 1 µm und 10 m angeordnet sind.

8. Vorrichtung nach einem der Ansprüche 1 bis 7, bei der ein frequenzselektives Element (14, 16, 22) im Freistrahlbereich (15) angeordnet ist.

9. Vorrichtung nach Anspruch 8, bei der das frequenzselektive Element ein Bragg-Gitter (16) ist.

10. Vorrichtung nach einem der Ansprüche 1 bis 9, bei der im Freistrahlbereich (15) ein abbildendes optisches Element (14) angeordnet ist.

11. Vorrichtung nach Anspruch 4 und 10, bei der das abbildende optische Element eine Zylinderlinse (14) ist, deren Brennlinie in der Ebene einer aktiven Zone (9) eines Breitstreifenlasers (1) an dessen Austrittsfenster liegt.

12. Vorrichtung nach einem der Ansprüche 1 bis 11, bei dem der Freistrahlbereich (15) von einem Medium mit geringem Absorptionskoeffizienten gebildet ist.

13. Vorrichtung nach Anspruch 4 und 12, bei dem der Freistrahlbereich (15) von einem Abschnitt mit einer Bandlücke gebildet ist, die größer als die Bandlücke im Pumpbereich ist.

## Claims

1. Device for emission of laser radiation with a pumped active zone of a semiconductor laser, said zone being arranged within a resonator (12, 13, 18, 19, 23), the active zone being subdivided into at least two spatially separate active zones (9) by free-radiation regions (15) without lateral wave guidance, **characterized in that**, from the other pumped active zone (9), one pumped active zone (9) appears at a sufficiently small solid angle such that higher modes of the resonator (12, 13, 18, 19, 23) experience a smaller amplification per resonator circulation than a fundamental mode of the resonator (12, 13, 18, 19, 23).

2. Device according to Claim 1,
in which at least two semiconductor lasers (1, 17), which are antireflection-coated at least on one side, are arranged in series, the resonator being formed by outer mirror elements (12, 13, 18, 19, 23) at the end of the semiconductor lasers (1, 17) arranged in series.

3. Device according to Claim 2,
in which the semiconductor lasers are two surface-emitting lasers (17), which are arranged at a distance in each case with an antireflection-coated top side facing one another.

4. Device according to Claim 2,
in which the semiconductor lasers are two broad-stripe lasers (1), which are arranged at a distance in each case with an antireflection-coated end face (10, 11) facing one another.

5. Device according to Claim 4,
in which the two broad-stripe lasers (1) are formed on a substrate (2).

6. Device according to one of Claims 2 to 5,
in which the semiconductor lasers (1, 17) are oriented with their optical axes parallel to one another.

7. Device according to one of Claims 2 to 6,
in which the semiconductor lasers (1, 17) are arranged at a distance of between 1 µm and 10 m.

8. Device according to one of Claims 1 to 7, in which a frequency-selective element (14, 16, 22) is arranged in the free-radiating region (15).

9. Device according to Claim 8,
in which the frequency-selective element is a Bragg grating (16).

10. Device according to one of Claims 1 to 9,
in which an imaging optical element (14) is arranged in the free-radiating region (15).

11. Device according to Claims 4 and 10,
in which the imaging optical element is a cylindrical lens (14), the focal line of which lies in the plane of an active zone (9) of a broad-stripe laser (1) at the exit window thereof.

12. Device according to one of Claims 1 to 11,
in which the free-radiating region (15) is formed by a medium with a low absorption coefficient.

13. Device according to Claims 4 and 12,
in which the free-radiating region (15) is formed by a section with a band gap which is greater than the band gap in the pump region.

## Revendications

1. Dispositif d'émission de rayonnement laser comprenant une zone active d'un laser à semi-conducteurs pompée et disposée à l'intérieur d'un résonateur (12, 13, 18, 19, 23), dans lequel la zone active est subdivisée par des régions (15) de faisceau libre sans guidage d'ondes latéral en au moins deux zones (9) actives séparées dans l'espace, **caractérisé en ce que** la zone (9) active pompée apparaît de l'autre zone (9) active pompée sous un angle solide suffisamment petit pour que des modes supérieurs du résonateur (12, 13, 18, 19, 23) subissent une amplification plus petite par cycle dans le résonateur qu'un mode fondamental du résonateur (12, 13, 18, 19, 23).

2. Dispositif suivant la revendication 1, dans lequel au moins deux lasers (1, 17) à semi-conducteurs traités au moins d'un côté de manière à atténuer les réflexions sont disposés en série, le résonateur étant formé d'éléments (12, 13, 18, 19, 23) extérieurs de miroir formés à l'extrémité des lasers (1, 17) à semi-conducteurs montés en série.

3. Dispositif suivant la revendication 2, dans lequel les lasers à semi-conducteurs sont deux lasers (17) à émission de surface qui sont disposés, respectivement, à distance en étant tournés l'un vers l'autre par un côté supérieur traité de manière à atténuer les réflexions.

4. Dispositif suivant la revendication 2, dans lequel les lasers à semi-conducteurs sont deux lasers (1) à bande large qui sont disposés, respectivement, à distance en étant tournés l'un vers l'autre par une face (10, 11) d'extrémité traitée de manière à atténuer les réflexions.

5. Dispositif suivant la revendication 4, dans lequel les deux lasers (1) à bande large sont constitués sur un substrat (2).

6. Dispositif suivant l'une des revendications 2 à 5, dans lequel les deux lasers (1, 17) à semi-conducteurs sont orientés avec ses axes optiques étant parallèles.

7. Dispositif suivant l'une des revendications 2 à 6, dans lequel les lasers (1, 17) à semi-conducteurs sont disposés à une distance comprise entre 1 µm et 10 m.

8. Dispositif suivant l'une des revendications 1 à 7, dans lequel un élément (14, 16, 22) sélectif en fréquence est disposé dans la région (15) du faisceau libre.

9. Dispositif suivant la revendication 8, dans lequel l'élément sélectif en fréquence est un réseau (16) de Bragg.

10. Dispositif suivant l'une des revendications 1 à 9, dans lequel un élément (14) optique de reproduction est disposé dans la région (15) de faisceau libre.

11. Dispositif suivant les revendications 4 et 10, dans lequel l'élément optique de reproduction est une lentille (14) cylindrique dont la ligne focale est dans le plan d'une zone (9) active d'un laser (1) à bande large à sa fenêtre de sortie.

12. Dispositif suivant l'une des revendications 1 à 11, dans lequel la région (15) de faisceau libre est formée par un milieu ayant un petit coefficient d'absorption.

13. Dispositif suivant les revendications 4 et 12, dans lequel la région (15) de faisceau libre est formée par une partie ayant un écart énergétique qui est plus grand que l' écart énergétique dans la région de pompage.
